# EUROPÄISCHE PATENTANMELDUNG

(11) **EP 4 644 935 A1**
(43) Veröffentlichungstag der Anmeldung: **05.11.2025**
(21) Anmeldenummer: 25173784.7
(22) Anmeldetag: 30.04.2025
(51) Int. Cl.: G01R 31/54, G01R 31/58, G01R 31/00

(54) **VERFAHREN SOWIE VORRICHTUNG ZUM PRÜFEN EINES KABELSATZES**

(30) Priorität: 03.05.2024 DE 102024204161
(71) Anmelder: LEONI Bordnetz-Systeme GmbH, 97318 Kitzingen (DE); LEONI Wiring Systems Slovakia spol. s r.o., 911 01 Trencin (SK); Leoni Wiring Systems UK Limited, Staffordshire ST5 9BT (GB)
(72) Erfinder: EGBERS, Andreas, 97340 Marktbreit (DE); YEOLE, Aniket, 97318 Kitzingen (DE); RAHMAN, Mehbub-Ur, 97318 Kitzingen (DE); MATAVA, Lubomir, 911 01 Trencin (SK); KALIANKO, Imrich, 91101 Trencín (SK); WEBB, Robert, Stoke-On-Trent, ST6 8HL (GB)
(74) Vertreter: FDST Patentanwälte

(57) **Zusammenfassung**

Bei dem Verfahren sowie der Vorrichtung zum Prüfen eines Kabelsatzes (4), welcher insbesondere für ein Fahrzeug vorgesehen ist und der eine Vielzahl von einzelnen Leitungen (10) mit jeweils zwei Leitungsenden (18) aufweist wird an das eine Leitungsende (18) einer jeweiligen einzelnen Leitung (10) jeweils ein Prüfsignal (P) von einer Sendeeinheit (14) angelegt und am anderen Leitungsende (18) von einer Empfangseinheit (16) erfasst, wobei mehrere Leitungen (10) gleichzeitig geprüft werden und hierzu unterschiedlich codierte Prüfsignale (P) angelegt werden. Hierdurch wird eine schnelle und zuverlässige Überprüfung des gesamten Kabelsatzes 4 erreicht.

## Beschreibung

Die Erfindung betrifft ein Verfahren sowie eine Vorrichtung zum Prüfen eines Kabelsatzes, welcher insbesondere für ein Fahrzeug vorgesehen ist und welcher eine Vielzahl von einzelnen Leitungen mit jeweils zwei Leitungsenden aufweist, wobei an das eine Leitungsende einer jeweiligen Einzelleitung jeweils ein Prüfsignal von einer Sendeeinheit angelegt und am anderen Leitungsende von einer Empfangseinheit erfasst wird.

Bei der Herstellung von Kabelsätzen beispielsweise für Kraftfahrzeuge werden die Kabelsätze üblicherweise am Ende der Kabelsatzfertigung auf ihre Funktionsfähigkeit hin überprüft. Dies erfolgt üblicherweise mithilfe von speziellen Prüfvorrichtungen, die auch als sogenannte Prüftische bezeichnet werden. Derartige Verfahren oder Prüftische sind beispielsweise aus DE 10 2020 112 283 A1 oder aus DE 10 2017 122 223 A1 zu entnehmen.

Üblicherweise werden bei derartigen Prüftischen die Einzelleitungen sukzessive getestet, insbesondere wird hierbei für jede Leitung eine Widerstandsmessung durchgeführt, um die Durchleitfähigkeit und damit Funktionsfähigkeit zu überprüfen.

Speziell in der Automobilindustrie ist die Überprüfung einer jeden einzelnen Leitung bei jedem Kabelsatz gefordert. Kabelsätze für Kraftfahrzeuge weisen häufig mehrere hundert einzelne Leitungen auf, sodass die Prüfung der Kabelsätze zeitaufwändig und damit auch kostenintensiv ist.

Ausgehend hiervon liegt der Erfindung die Aufgabe zugrunde, ein Verfahren sowie eine Vorrichtung zum Prüfen eines Kabelsatzes mit geringem Zeitbedarf für die Prüfung anzugeben.

Die Aufgabe wird gemäß der Erfindung gelöst durch ein Verfahren sowie eine Vorrichtung zum Prüfen eines Kabelsatzes, welcher insbesondere für ein Fahrzeug vorgesehen ist und welcher eine Vielzahl von einzelnen, insbesondere elektrischen Leitungen aufweist. Eine jeweilige Leitung weist zumindest zwei Leitungsenden auf, wobei für die Prüfung an das eine Leitungsende jeweils ein Prüfsignal von einer Sendeeinheit angelegt und am anderen Leitungsende von einer Empfangseinheit erfasst wird. Bei der Durchführung der Prüfung werden mehrere Leitungen gleichzeitig geprüft, wobei hierzu unterschiedlich codierte Prüfsignale angelegt werden.

Korrespondierend hierzu weist die Vorrichtung zumindest eine Sendeeinheit zum Einspeisen jeweils eines Prüfsignals in die einen Leitungsenden und zumindest eine Empfangseinheit zum Erfassen des jeweiligen Prüfsignals an den anderen Leitungsenden auf. Die Vorrichtung ist insgesamt derart ausgebildet, dass im Betrieb mehrere Leitungen gleichzeitig geprüft werden und hierzu unterschiedlich codierte Prüfsignale angelegt werden. Die nachfolgend im Hinblick auf das Verfahren angegebenen Vorteile und bevorzugten Ausgestaltungen sind sinngemäß auch auf die Vorrichtung zu übertragen. Bei der Vorrichtung handelt es sich insbesondere um einen sogenannten Prüftisch, auf dem der gesamte Kabelsatz aufgelegt wird und welcher Anschlussstellen aufweist, an denen die Leitungsenden angeschlossen werden können. Diese Anschlussstellen sind durch die zumindest eine Sendeeinheit bzw. durch die zumindest eine Empfangseinheit bereitgestellt oder mit diesen verbunden.

Durch die kombinierte Maßnahme der zeitgleichen Einspeisung von Prüfsignalen in mehrere einzelne Leitungen in Verbindung mit der Verwendung von unterschiedlich codierten Prüfsignalen wird zum einen der Zeitbedarf für die Überprüfung des gesamten Kabelsatzes im Vergleich zu einer sukzessiven einzelnen Prüfung der einzelnen Leitungen erheblich reduziert. Zum anderen wird durch die unterschiedliche Codierung der gleichzeitig eingespeisten Prüfsignale eine zuverlässige und fehlerfreie Prüfung gewährleistet. Denn durch die unterschiedlich codierten Prüfsignalen ist eine eindeutige Zuordnung eines jeweiligen Prüfsignals zu der jeweiligen Leitung gewährleistet. Durch die unterschiedliche Codierung unterschieden sich die Prüfsignale voneinander und lassen sich eindeutig voneinander unterscheiden. Bevorzugt werden zeitgleich ausschließlich unterschiedlich codierte Prüfsignale eingespeist. Es ist hierdurch sichergestellt, dass trotz der gleichzeitigen Prüfung von mehreren Leitungen jede einzelne Leitung zuverlässig im Hinblick auf ihre Funktionsfähigkeit überprüft werden kann. Insbesondere können die geprüften Leitungen zuverlässig unterschieden werden. Bei der Verwendung von identischen Prüfsignalen wäre demgegenüber eine verwechslungssichere Überprüfung nicht ohne weiteres zu gewährleisten.

Für die Funktionsprüfung wird überprüft, ob das von der Empfangseinheit erfasste Prüfsignal identisch zum (eindeutig codierten) eingespeisten Prüfsignal ist. Ist dies der Fall, so ist die Prüfung erfolgreich. Wird demgegenüber lediglich ein unklares Signal oder auch kein Signal erfasst, so gilt die Prüfung als nicht erfolgreich. Bei einer nicht erfolgreichen Prüfung wird üblicherweise der gesamte Kabelsatz als nicht in Ordnung verworfen.

Die Prüfung erfolgt hierbei insbesondere auf Durchlässigkeit, es wird also speziell eine Widerstandsmessung durchgeführt. Ergänzend wird insbesondere auch mit dieser Widerstandsmessung eine Überprüfung auf einen Kurzschluss zwischen zwei Leitungen durchgeführt. Bei einem solchen Kurzschlussfall kommt das eingespeiste Prüfsignal nicht oder allenfalls stark modifiziert am anderen Leitungsende der zu prüfenden Leitung an.

Bei der Prüfung werden insbesondere sämtliche einzelne Leitungen des Kabelsatzes und zwar üblicherweise in mehreren aufeinanderfolgenden Prüfschritten geprüft. Pro Prüfschritt werden gleichzeitig mehrere einzelne Leitungen geprüft und hierzu die unterschiedlich codierten Prüfsignale eingespeist. Beispielsweise werden pro Prüfschritt zeitgleich mindestens 3, bevorzugt mindestens 5 oder 10 oder auch zumindest 20 einzelne Leitungen gleichzeitig geprüft. Typischerweise werden 3 bis 10 einzelne Leitungen gleichzeitig überprüft.

Eine jeweilige Leitung weist typischerweise genau zwei Leitungsenden auf, erstreckt sich daher von dem einen Leitungsende bis zum anderen Leitungsende. Alternativ kann es sich auch um Leitungen handeln, bei denen ein zunächst einzelner Leitungsstrang beispielsweise durch Spleißen auf zwei oder auch mehrere Teilstränge aufgeteilt wird. In diesem Fall weist die Leitung dann mehr als zwei Leitungsenden auf.

Die Prüfung erfolgt weiterhin regelmäßig vor dem Einbau des Kabelsatzes für seine bestimmungsgemäße Verwendung, speziell also vor dem Einbau in ein Kraftfahrzeug. Die Prüfung erfolgt typischerweise beim Hersteller des Kabelsatzes, bevor er anschließend verpackt und an einen Einbauort versendet wird.

Bei dem Kabelsatz handelt es sich bevorzugt um einen endkonfektionierten, einbaufertigen Kabelsatz, bei dem die Einzelleitungen an Stecker angeschlossen sind, d. h. bei der Prüfung wird insbesondere auch überprüft, ob die Leitungen korrekt an den Steckern angeschlossen sind. Üblicherweise sind mehrere Leitungen gemeinsam an einem jeweiligen Stecker angeschlossen.

Bevorzugt werden zumindest teilkonfektionierte Kabelsätze geprüft, bei denen also beispielsweise die Leitungen noch nicht oder zumindest noch nicht alle an Stecker angeschlossen sind. Speziell bei der Prüfung von verdrillten Leitungen ist dies relevant, da diese aufgrund technischer Gegebenheiten gleichzeitig gesteckt werden müssen. Durch die Kodierung wird direkt erkannt, falls diese falsch gesteckt werden.

Die Messzeit pro Prüfschritt, bei dem jeweils mehrere einzelne Leitungen geprüft werden, liegt typischerweise bei kleiner 10 ms und insbesondere bei kleiner 1 ms. Die einzelnen Prüfschritte folgen unmittelbar aufeinander, so dass durch die Messzeit zugleich auch eine Taktzeit für die aufeinanderfolgenden Prüfschritte definiert ist.

Die Sendeeinheit ist allgemein dazu eingerichtet, das codierte Prüfsignal zu erzeugen. Sie ist beispielsweise durch ein steuerbares Netzteil verwirklicht oder weist zumindest ein solches auf. Für die Erzeugung der verschiedenen Prüfsignale sind beispielsweise mehrere Sendeeinheiten vorgesehen. Bevorzugt ist die eine Sendeeinheit jedoch zur Erzeugung und gleichzeitigen Abgabe der unterschiedlichen Prüfsignale ausgebildet.

Umgekehrt ist die zumindest eine Empfangseinheit zum Erfassen des Prüfsignals ausgebildet und ist daher als Messelement und insbesondere als ein Multimeter ausgebildet oder weist zumindest ein solches auf.

Insgesamt wird durch die hier beschriebenen Maßnahmen eine effiziente, zügige sowie genaue und zuverlässige Prüfung eines Kabelsatzes erreicht.

In bevorzugter Ausgestaltung handelt es sich bei dem Prüfsignal um ein analoges Signal. Die unterschiedlich codierten Prüfsignale unterscheiden sich daher untereinander durch zumindest einen und vorzugsweise genau einen analogen Kennwert. Bevorzugt unterscheiden sich die codierten Prüfsignale im Hinblick auf die Amplitude, beispielsweise einer angelegten Prüfspannung oder eines eingespeisten Prüfstroms, und/oder im Hinblick auf eine Frequenz des angelegten analogen Signals. Bevorzugt unterscheiden sich die codierten analogen Prüfsignalen jedoch lediglich im Hinblick auf ihre Amplitude. Als analoges Prüfsignal wird beispielsweise eine konstante Spannung oder ein konstanter Strom angelegt bzw. eingekoppelt. Bevorzugt werden ausschließlich analoge Prüfsignale eingesetzt.

Alternativ zu einem analogen Signal handelt es sich bei dem Prüfsignal um ein digitales Signal mit einzelnen Signalpulsen, wobei sich die unterschiedlich codierten Prüfsignale im Hinblick auf zumindest eines der Merkmale Pulsfrequenz, Pulshöhe, Pulsdauer, Pulsverlauf / Pulsmodulation unterscheiden. Ein jeweiliges digitales Signal weist dabei typischerweise mehrere Signalpulse auf, also eine Pulsfolge, wobei die einzelnen Pulse dabei insbesondere einen charakteristischen Verlauf beispielsweise mit ansteigender oder abfallender Pulshöhe, variierender Pulsbreite usw. aufweisen (Pulsmodulation).

Für das Prüfsignal wird insbesondere eine Prüfspannung von kleiner 14 V, vorzugsweise kleinergleich 12 V und / oder ein Prüfstrom von kleiner 100 mA und insbesondere von kleiner 50 mA oder kleiner 40mA eingesetzt. Die unterschiedlich codierten Prüfsignale weisen unterschiedliche Prüfspannungen und / oder Prüfströme auf. Sie unterscheiden sich beispielsweise in Schritten von 0,5 V, von 1,0 V, von 1,5 V und / oder von 2,0 V. Analog unterscheiden sich die Prüfströme beispielsweise in Schritten von 1 mA, von 2 mA, von 3 mA und / oder von 5 mA.

Die zumindest eine Sendeeinheit ist entsprechend zur Erzeugung von derartigen analogen/digitalen, codierten Signalen eingerichtet und ausgebildet. Entsprechend ist auch die zumindest eine Empfangseinheit geeignet zum Empfangen und Auswerten derartiger Prüfsignale eingerichtet.

In bevorzugter Ausgestaltung sind die einzelnen Leitungen unterschiedlichen Gruppen zugeordnet, wobei die Zuordnung zu einer Gruppe auf Basis zumindest eines der folgenden Merkmale erfolgt:
- Auf Basis der Leitungsart:
   Unter Leitungsart wird der physikalische Aufbau der Leitung verstanden, insbesondere ob es sich um eine einzelne Ader (also um einen mit einer Isolierung versehenen Leiter), um ein verdrilltes Adernpaar oder auch um einen anderen Leitungstyp wie beispielsweise eine Koaxial-Leitung handelt. Alternativ oder ergänzend wird die Zuordnung zu einer Gruppe anhand des Leiterquerschnitt vorgenommen.
- Auf Basis der Leitungsfunktion:
   Hierunter wird insbesondere verstanden, ob die Leitung als eine Datenleitung, also zu Kommunikationszwecken oder als eine Versorgungsleitung, also zur elektrischen Leistungsversorgung vorgesehen und ausgebildet ist.
- Auf Basis einer zugeordneten räumlichen Funktionszone im eingebauten Zustand speziell im Kraftfahrzeug:
   Hierunter wird verstanden, für welchen räumlichen Funktionsbereich (räumliche Zone) innerhalb des Kraftfahrzeugs die Leitung vorgesehen ist, welche also mit der Leitung angebunden oder versorgt wird. Typische Zonen innerhalb eines Kraftfahrzeugs sind beispielsweise ein Türmodul, ein Heckmodul, ein Frontmodul, ein Armaturenmodul usw.
- Auf Basis einer Anzahl der Leitungsenden einer jeweiligen Leitung, bzw.
   auf Basis der Anzahl der Spleiße, also Abzweigungen innerhalb der jeweiligen Leitung.

In zweckdienlicher Ausgestaltung werden für die verschiedenen Gruppen unterschiedliche, gruppenspezifische Prüfsignale verwendet. Dies bedeutet, dass für alle Leitungen, die einer Gruppe zugeordnet sind, identisch codierte Prüfsignale verwendet werden. Dies beruht insbesondere auf der Überlegung, dass - beispielsweise bei der Gruppierung nach Leitungsart und/oder Leitungsfunktion - die Leitungen bestimmte physikalische Eigenschaften, wie beispielsweise ein Dämpfungsverhalten aufweisen. Abgestimmt auf diese gruppenspezifischen physikalischen Leitungseigenschaften wird ein geeignetes Prüfsignal eingesetzt, um sicherzustellen, dass auf Empfängerseite zuverlässig das Prüfsignal ankommt.

Beim den gruppenspezifischen Prüfsignalen handelt es sich insbesondere um die unterschiedlich codierten Prüfsignale. Insgesamt ist für die gruppenspezifische Codierung beispielsweise eine gruppenspezifische Prüfspannung und / oder ein gruppenspezifischer Prüfstrom vorgesehen.

Pro Gruppe wird bei einem Prüfschritt beispielsweise jeweils lediglich nur eine Leitung geprüft, d. h. pro Gruppe werden nicht mehrere Leitungen gleichzeitig geprüft. Alternativ werden pro Gruppe auch mehrere Leitungen bei einem Prüfschritt gleichzeitig geprüft.

Eine jeweilige Gruppe weist mehrere und insbesondere vorzugsweise mehr als 5 oder mehr als 10 und vorzugsweise mehr als 50 einzelne Leitungen auf.

Allgemein weist der Kabelsatz in bevorzugter Ausgestaltung mehrere hundert einzelne Leitungen auf, zum Beispiel mehr als 200, mehr als 400 oder auch mehr als 500 einzelne Leitungen. Bei dem Kabelsatz handelt es sich beispielsweise um einen gesamten Kabelsatz für ein Kraftfahrzeug. Der Kabelsatz wird auf dem Prüftisch angeschlossen und in verschiedenen aufeinanderfolgenden Prüfschritten sukzessive vollständig durchgeprüft. Alternativ oder ergänzend können auf dem Prüftisch auch mehrere (Teil-) Kabelsätze gleichzeitig angeordnet und gleichzeitig geprüft werden.

Der Prüftisch weist entsprechend auch eine ausreichende Anzahl an Anschlussstellen zum Einspeisen bzw. Empfangen der Prüfsignale auf. Eine jede einzelne Leitung (mit jedem ihrer Leitungsenden) ist also an jeweils einer ihr zugeordneten Anschlussstelle des Prüftisches angeschlossen und über diese mit der zumindest einen Sendeeinheit / Empfangseinheit verbunden.

Eine jeweilige Sendeeinheit / Empfangseinheit weist beispielsweise jeweils mehrere Kanäle als Anschlussstellen für die Leitungen auf. Bevorzugt ist eine jeweilige Sendeeinheit zur gleichzeitigen Bereitstellung von unterschiedlichen Prüfsignalen an den Anschlussstellen ausgebildet.

In bevorzugter Ausgestaltung weist der Prüftisch mehrere Prüfmodule auf, wobei an einem jeweiligen Prüfmodul jeweils mehrere einzelne Leitungen angeschlossen sind. Bevorzugt weist ein jeweiliges Prüfmodul zumindest eine, insbesondere mehrkanalige Sendeeinheit und/oder zumindest eine, insbesondere mehrkanalige Empfangseinheit auf oder ist mit einer solchen verbunden.

Die einzelnen Leitungen werden an einem jeweiligen Prüfmodul bevorzugt über die an den einzelnen Leitungen angeschlossenen Stecker angeschlossen. Alternativ oder ergänzend sind an einen Prüfmodul auch mehrere Stecker angeschlossen.

Bei dem Verfahren werden bevorzugt höherpolige Stecker mit der Empfängereinheit verbunden und niedrigpolige Stecker vorzugsweise mit der Sendeeinheit. Dies ermöglicht es, mehr einzelne Leitungen parallel zu testen. Eine umgekehrte Anordnung ist alternativ auch möglich.

Der Prüftisch ist allgemein vorzugsweise als ein modular aufgebauter Prüftisch ausgebildet, an dem einzelne Prüfmodule an Modulplätzen angeordnet werden können. Dies bedeutet, dass die Position der einzelnen Prüfmodule am Prüftisch variabel ist und für einen jeweiligen Kabelsatz dann entsprechend eine spezifische Prüfmodul-Konfiguration ausgebildet wird.

In zweckdienlicher Ausgestaltung werden üblicherweise mehr als 2, insbesondere mehr als 5 oder mehr als 10 und insbesondere mehr als 50 Prüfmodule für die Prüfung des Kabelsatzes eingesetzt.

Bevorzugt handelt es sich bei den Prüfmodulen um multifunktionale Prüfmodule, die sowohl zum Erzeugen und Einspeisen als auch zum Erfassen der Prüfsignale ausgebildet sind. Ein jedes Prüfmodul weist zumindest eine insbesondere mehrkanalige Sendeeinheit und ergänzend auch zumindest eine, insbesondere mehrkanalige Empfangseinheit auf. Ein jedes Prüfmodul kann daher wahlweise zum Senden oder auch als Empfangseinheit eingesetzt werden. Ein jedes Prüfmodul ist bevorzugt dazu ausgelegt, gleichzeitig unterschiedliche Prüfsignale zu erzeugen und bereitzustellen.

In bevorzugter Ausgestaltung ist die zumindest eine Sendeeinheit und sind die Prüfmodule jeweils insbesondere individuell konfigurierbar, beispielsweise mittels Software geeignet parametrierbar, so dass die gewünschten Prüfsignale erzeugt und bereitgestellt werden.

Ein jeweiliges Prüfmodul weist eine Vielzahl von Anschlüssen für die einzelnen Leitungen auf, wobei jeder Anschluss quasi einen eigenen Kanal definiert. D. h. ein jeweiliges Prüfmodul weist typischerweise eine Vielzahl von unterschiedlichen Sendekanälen sowie eine Vielzahl von unterschiedlichen Empfangskanälen auf.

Die über die einzelnen Sendekanäle abgegebenen, insbesondere unterschiedlichen Prüfsignale werden beispielsweise über eine geeignete Software konfiguriert und eingestellt. Entsprechend werden bevorzugt auch die Empfangskanäle geeignet parametrisiert und auf die zu empfangenden Prüfsignalen eingestellt, beispielsweise für eine Strommessung oder eine Spannungsmessung.

In bevorzugter Weiterbildung handelt es sich bei den Prüfmodule um intelligente Prüfmodule, die zur Auswertung der erfassten Prüfsignalen ausgebildet sind. D. h. das intelligente Prüfmodul entscheidet bereits selbsttätig, ob die überprüfte Leitung in Ordnung oder nicht in Ordnung ist. Das Ergebnis dieser Auswertung wird vorzugsweise an eine übergeordnete Auswerteeinheit weitergeleitet, die dann vorzugsweise die übermittelten Auswertungen der verschiedenen Prüfmodule sammelt und insbesondere auch an einem Ausgabegerät beispielsweise visualisiert für einen Benutzer ausgibt.

Ergänzend oder alternativ werden die erfassten Einzelwerte an die übergeordnete Auswerteeinheit übermittelt.

In bevorzugter Ausgestaltung sind an einem jeweiligen Prüfmodul Leitungen von unterschiedlichen Gruppen angeschlossen. Dies ist beispielsweise dann der Fall, wenn an einem Teilstrang des Kabelsatzes Leitungen unterschiedlicher Leitungsfunktion oder unterschiedlicher Leitungsart, beispielsweise Versorgungsleitungen und Datenleitungen, miteinander kombiniert sind, die gemeinsam an einem Prüfmodul angeschlossen sind. Alternativ sind an einem Prüfmodul jeweils nur Leitungen einer gleichen Gruppe angeschlossen. Dies ist beispielsweise dann der Fall, wenn an einem Stecker lediglich Leitungen gleicher Leitungsart / gleicher Leitungsfunktion, beispielsweise lediglich Datenleitungen angeschlossen sind.

Gemäß einer bevorzugten Ausgestaltung wird - insbesondere bei einem jeweiligen Prüfschritt bei einer Vielzahl von aufeinanderfolgenden Prüfschritten - nur ein Teil der einzelnen Leitungen mit den codierten Prüfsignalen gleichzeitig beaufschlagt. Gleichzeitig werden jedoch zumindest einige und vorzugsweise alle weiteren einzelnen Leitungen zeitgleich im Hinblick auf das Erfassen eines Prüfsignals überprüft. Hierdurch wird insbesondere auch ein Kurzschluss zwischen Leitungen erfasst, wenn also beispielsweise festgestellt wird, dass ein Prüfsignal an einer Empfangseinheit erfasst wird, wobei in die daran angeschlossene Leitung kein Prüfsignal eingespeist wurde.

Ein Ausführungsbeispiel der Erfindung wird nachfolgend anhand der Figuren näher erläutert. Diese zeigen in vereinfachten Darstellungen:
- FIG 1: eine Aufsicht auf einen Prüftisch mit darauf angebrachtem Kabelsatz,
- FIG 2: eine schematisierte Darstellung zweier Prüfmodule, die an einer gemeinsamen Sende-, und Empfangseinheit angeschlossen sind zur Überprüfung von mehreren Einzelleitungen, sowie
- FIG 3: eine schematisierte Darstellung eines Prüftisches mit in Gruppen eingeteilten Leitungen, die an intelligenten Prüfmodulen angeschlossen sind.

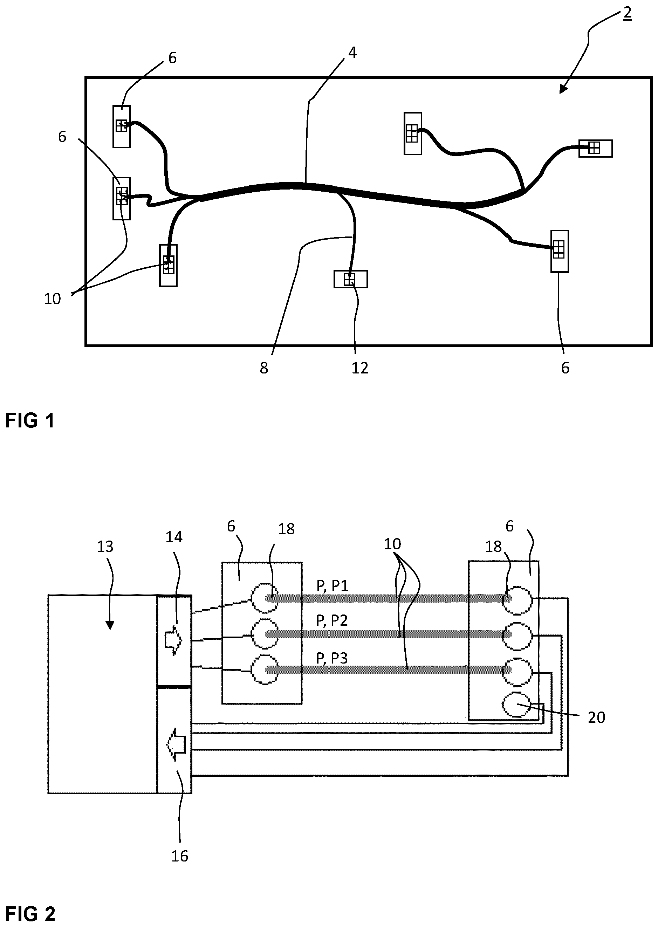

FIG 1 zeigt eine Aufsicht auf einen Prüftisch 2 für die Funktionsprüfung eines darauf temporär für die Prüfung angebrachten Kabelsatzes 4. Der Prüftisch 2 ist üblicherweise modular aufgebaut und weist eine Vielzahl von einzelnen Prüfmodulen 6 auf, die am Prüftisch 2 weitgehend frei, beispielsweise entlang eines vorgegebenen Rastermaßes positionierbar sind. Hierzu sind typischerweise am Prüftisch 2 entsprechende Steckplätze für ein jeweiliges Prüfmodul 6 vorgesehen. Ein solcher Prüftisch 2 weist üblicherweise eine Länge sowie Breite von mehreren Metern auf, beispielsweise eine Breite von zumindest 0,5 m, vorzugsweise von zumindest 1m bis 2 m und eine Länge von zumindest 1 m, insbesondere von zumindest 2m bis 7 m. Alternativ zu einem Prüftisch 2 kann auch ein Prüfbrett verwendet werden.

Der Kabelsatz 4 weist üblicherweise eine verzweigte Struktur auf mit mehreren abzweigenden Kabelsträngen 8, die üblicherweise selbst wiederum mehrere einzelne elektrische Leitungen 10 aufweisen, die typischerweise endseitig an einem jeweiligen Stecker 12 angeschlossen sind. Im Ausführungsbeispiel ist an einem jeweiligen Prüfmodul 6 jeweils genau ein Kabelstrang 8 mittels eines Steckers 12 angeschlossen. Grundsätzlich besteht auch die Möglichkeit, dass an einen Prüfmodul 6 mehrere Kabelstränge 8 bzw. mehrere Stecker 12 angeschlossen sind.

Die Funktionsprüfung des Kabelsatzes 4 erfolgt üblicherweise am Ende der Kabelsatzfertigung, bevor also dieser an seinen bestimmungsgemäßen Einbauort eingebaut wird. Typischerweise erfolgt die Prüfung beim Hersteller des Kabelsatzes und wird nach der Prüfung an einen Einbauort versendet. Speziell handelt es sich bei dem Kabelsatz 4 um einen Kabelsatz 4, welcher in der montierten Endstellung in einem Kraftfahrzeug angebracht ist.

Für die Prüfung des Kabelsatzes 4 wird jede einzelne Leitung 10 individuell im Hinblick auf ihre Durchlässigkeit geprüft, wobei hierzu typischerweise eine Widerstandsmessung durchgeführt wird.

Der Prüftisch 2 weist häufig eine interne Verdrahtung auf, über die die einzelnen Steckplätze für die Prüfmodule 6 und damit auch die Prüfmodule 6 geeignet angeschlossen und beispielsweise mit einer zentralen Einspeise- und Auswerteeinheit 13 (vergleiche hierzu beispielsweise FIG 2) verdrahtet sind. In einem solchen Fall handelt es sich bei den Prüfmodulen 6 beispielsweise lediglich um einfache Steckbuchsen, die dann über die interne Verdrahtung mit der zentralen Einspeise- und Auswerteeinheit 13 verbunden sind.

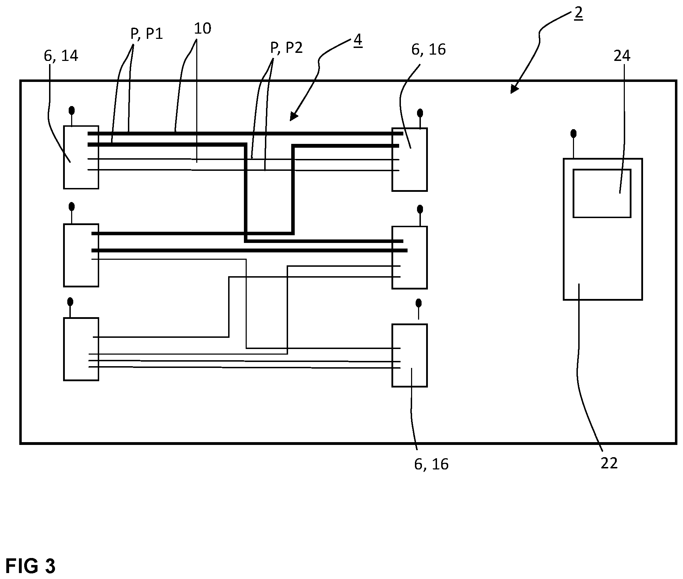

In bevorzugter Ausgestaltung sind die Prüfmodule 6 jedoch selbst entweder als Sendeeinheiten 14 und/oder als Empfangseinheiten 16 ausgebildet. Insbesondere sind sie jeweils als kombinierte Sende- und Empfangseinheiten ausgebildet, die also wahlweise zum Einspeisen als auch zum Erfassen von Prüfsignalen P ausgebildet sind (vgl. hierzu z. B. FIG 3).

Speziell sind sie als intelligente Prüfmodule 6 ausgebildet, die zugleich eine integrierte Auswerteeinheit aufweisen, über die die empfangenen Prüfsignale P dahingehend ausgewertet werden, ob die jeweils geprüfte Leitung 10 in Ordnung oder nicht in Ordnung ist.

Der besondere Vorteil derartiger kombinierter und/ oder intelligenter Prüfmodule 6 ist unter anderem in einem reduzierten Verdrahtungsaufwand für den Prüftisch 2 zu sehen. Die verschiedenen intelligenten Prüfmodule 6 kommunizieren beispielsweise über einen Datenbus miteinander.

Anhand der FIG 2 wird in einer stark vereinfachten Darstellung die zeitgleiche Prüfung von beispielhaft drei dargestellten Leitungen 10 illustriert. Diese sind mit ihren Leitungsenden 18 an zwei Prüfmodulen 6 und zwar einer jeweiligen Anschlussstelle/Kanal des jeweiligen Prüfmoduls 6 angeschlossen.

Im dargestellten Ausführungsbeispiel der FIG 2 sind die beiden Prüfmodule 6 über eine Verdrahtung mit der zentralen Sende- und Empfangseinheit 13 verbunden. Diese weist eine mehrkanalige Sendeeinheit 14 sowie eine mehrkanalige Empfangseinheit 16 auf. An einer jeweiligen Anschlussstelle/Kanal der mehrkanaligen Sendeeinheit 14 wird bei der Prüfung jeweils ein codiertes Prüfsignal P1 - P3 angelegt. Die Prüfsignale P1 - P3 werden daher innerhalb der mehrkanaligen Sendeeinheit 14 erzeugt. Diese weist daher mehrere einzelne Erzeugungseinheiten/Schaltkreise zur Erzeugung der unterschiedlichen Prüfsignale P1 - P3 auf.

Analog weist auch die mehrkanalige Empfangseinheit 16 pro Anschlussstelle/Kanal eine individuelle, beispielsweise durch einen Schaltkreis gebildete Empfangseinheit auf.

Die unterschiedlich codierten Prüfsignal P1 - P3 weisen diese insbesondere unterschiedliche Spannungshöhen auf. Allgemein werden bei der Prüfung vorzugsweise analoge (Gleich-) Spannungssignale mit einem Spannungswert von kleiner 14 V und/oder analoge (Gleich-) Stromsignale mit einem Stromwert von geringer 50 mA als Prüfsignale P1 -P3 zeitgleich eingespeist.

Die empfangenen Prüfsignale P1 - P3 werden durch die mehrkanalige Empfangseinheit 16 ausgewertet und insbesondere mit den eingespeisten Prüfsignalen P1 - P3 verglichen.

Gemäß FIG 2 weist das auf der rechten Seite dargestellte Prüfmodul 6, welches mit der mehrkanaligen Empfangseinheit 16 verbunden ist, zusätzlich noch einen unbelegten Anschlusspunkt auf, welcher als Testpunkt 20 bezeichnet wird. Dieser dient sinnbildlich der Darstellung von Steckern des Kabelsatzes, welche beispielsweise nicht mit Leitungen belegt sind, allerdings u.U. durch eine fehlerhafte Bestückung einen Kurzschluss verursachen, welcher erkannt werden kann.

In FIG 3 ist in einer stark vereinfachten schematisierte Darstellung ein Prüftisch 2 mit intelligenten und kombinierten Prüfmodulen 6 dargestellt. Der Kabelsatz 4 weist eine Vielzahl von Leitungen 10 auf, die unterschiedlichen Gruppen zugeordnet sind. Im Ausführungsbeispiel sind zwei Gruppen durch unterschiedliche Strichstärken dargestellt. Bei der einen Gruppe handelt es sich beispielsweise um Versorgungsleitungen mit einem größeren Leitungsdurchmesser und bei der anderen Gruppe beispielsweise um Datenleitungen mit einem geringeren Leitungsdurchmesser.

Die Prüfmodule 6 sind jeweils als mehrkanalige Prüfmodule 6 ausgebildet. Bevorzugt sind die Prüfmodule 6 identisch ausgebildet und weisen jeweils eine integrierte Sendeeinheit 14 sowie Empfangseinheit 16 auf. Im Ausführungsbeispiel sind die auf der linken Seite dargestellten Prüfmodule 6 als Sendeeinheiten 14 und die auf der rechten Seite dargestellten Prüfmodule 6 als Empfangseinheiten 16 ausgebildet. Die Prüfmodule 6 sind bevorzugt konfigurierbar, insbesondere sind die einzelnen Anschlussstellen/Kanäle beispielsweise mit unterschiedlichen Prüfsignalen P1, P2 belegbar. Hervorzuheben ist, dass ein jeweiliges Prüfmodul 6 auch gleichzeitig mehrere Prüfsignale P1, P2 mit unterschiedlicher Codierung bereitstellen kann.

Die verschiedenen Prüfmodule 6 stehen mit einer zentralen Auswerteeinheit 22 beispielsweise über einen Datenbus in Kommunikationsverbindung. Die Auswerteeinheit 22 weist beispielsweise eine Ausgabeeinheit 24 zur Ausgabe, insbesondere zur grafischen Darstellung der Testergebnisse auf.

Wie zu erkennen ist, sind an einem Prüfmodul 6 Leitungen 10 unterschiedlicher Gruppen angeschlossen.

Für jede Gruppe wird ein gruppenspezifisches Prüfsignal P1, P2 bereitgestellt. Bei der Prüfung werden nunmehr jeweils eine Leitung einer jeweiligen Gruppe zeitgleich mit den unterschiedlich codierten Prüfsignalen P1, P2 beaufschlagt. Anschließend werden die jeweils nächsten Leitungen 10 einer jeweiligen Gruppe mit dem entsprechenden gruppenspezifischen Prüfsignal P1, P2 beaufschlagt.

Während eines jeweiligen Prüfschritts werden daher unterschiedliche Prüfsignale P1, P2 in die einzelnen Leitungen 10 eingespeist. Auf der Seite der Empfangseinheiten 16 werden vorzugsweise ergänzend gleichzeitig sämtliche weitere Leitungen 10 überprüft, um beispielsweise einen Kurzschluss detektieren zu können.

Allgemein wird anhand des gemessenen Prüfsignals P, beispielsweise anhand des gemessenen Spannungswerts und/oder des gemessenen Stroms, speziell ein Widerstandswert ermittelt, aufgrund dessen dann bestimmt werden kann, ob die Leitung 10 in Ordnung ist. Dies erfolgt im Ausführungsbeispiel dezentral innerhalb eines jeweiligen intelligenten Prüfmoduls 6. Das Ergebnis der Auswertung wird an die zentrale Auswerteeinheit 22 übermittelt.

Zur Prüfung sämtlicher Leitungen 10 werden sukzessive eine Vielzahl von Prüfschritten durchgeführt, bis alle Leitungen 10 der verschiedenen Gruppen durchgeprüft sind.

Über die intelligenten Prüfmodule 6 besteht die Möglichkeit, weitere Funktionen festzulegen. So wird beispielsweise bei Bedarf ein Kanal oder werden mehrere der Kanäle auf Massepotential gelegt, um beispielsweise ein Referenzpotential zu definieren. Ergänzend wird beispielsweise ein spezielles Signal eingespeist, welches mittels eines Sensors entlang des Kabelsatzes 4 erfasst werden kann, um beispielsweise den Verlegeweg einer Leitung 10 überprüfen zu können.

Insgesamt wird durch die hier beschriebene Prüfung aufgrund der zeitgleichen Messung mittels codierten Prüfsignalen P1 - P3 eine schnelle und genaue Überprüfung des gesamten Kabelsatzes 4 erreicht.

### Bezugszeichenliste

- 2: Prüftisch
- 4: Kabelsatz
- 6: Prüfmodul
- 8: Kabelstrang
- 10: Leitung
- 12: Stecker
- 13: zentrale Sende- und Empfangseinheit
- 14: Sendeeinheit
- 16: Empfangseinheit
- 18: Leitungsende
- 20: Testpunkt
- 22: Auswerteeinheit
- 24: Ausgabeeinheit

- P: Prüfsignal
- P1-P3: unterschiedlich codierte Prüfsignale

## Patentansprüche

1. Verfahren zum Prüfen eines Kabelsatzes (4), insbesondere für ein Fahrzeug mit einer Vielzahl von einzelnen Leitungen (10), die jeweils zwei Leitungsenden (18) aufweisen, wobei an das eine Leitungsende (18) einer jeweiligen einzelnen Leitung (10) jeweils ein Prüfsignal (P) von einer Sendeeinheit (14) angelegt und am anderen Leitungsende (18) von einer Empfangseinheit (16) erfasst wird, wobei mehrere Leitungen (10) gleichzeitig geprüft werden und hierzu unterschiedlich codierte Prüfsignale (P) angelegt werden.

2. Verfahren nach Anspruch 1, wobei es sich bei dem Prüfsignal (P) um ein analoges Signal handelt und die unterschiedlich codierten Prüfsignale (P) sich im Hinblick auf Amplitude und / oder Frequenz unterscheiden.

3. Verfahren nach Anspruch 1, wobei es sich bei dem Prüfsignal (P) um ein digitales Signal mit einzelnen Signalpulsen handelt und die unterschiedlich codierten Prüfsignale (P) sich im Hinblick auf zumindest eines der Merkmale Pulsfrequenz, Pulshöhe, Pulsdauer, Pulsverlauf unterscheiden.

4. Verfahren nach einem der vorhergehenden Ansprüche, bei dem für das Prüfsignal (P) eine Prüfspannung von kleiner 14V und / oder ein Prüfstrom von kleiner 100mA, eingesetzt wird.

5. Verfahren nach einem der vorhergehenden Ansprüche, bei dem die einzelnen Leitungen (10) unterschiedlichen Gruppen zugeordnet werden, wobei die Zuordnung zu einer Gruppe auf Basis zumindest eines der folgenden Merkmale erfolgt:
- Leitungsart,
- Leitungsfunktion,
- räumliche Funktionszone im eingebauten Zustand,
- Anzahl der Leitungsenden.

6. Verfahren nach einem der vorhergehenden Ansprüche, bei dem die einzelnen Leitungen (10) unterschiedlichen Gruppen zugeordnet werden und für die verschiedenen Gruppen unterschiedliche, gruppenspezifische Prüfsignale (P) verwendet werden.

7. Verfahren nach dem vorhergehenden Anspruch, bei dem es sich bei den gruppenspezifischen Prüfsignalen (P) um die unterschiedlich codierten Prüfsignale (P) handelt.

8. Verfahren nach einem der Ansprüche 5 bis 7, bei dem eine jeweilige Gruppe mehr als 5 und vorzugsweise mehr als 50 einzelne Leitungen (10) aufweist.

9. Verfahren nach einem der vorhergehenden Ansprüche, bei dem mehrere Prüfmodule (6) vorgesehen sind, wobei an einem jeweiligen Prüfmodul (6) jeweils mehrere einzelne Leitungen (10) angeschlossen sind und wobei ein jeweiliges Prüfmodul (6) zumindest eine Sendeeinheit (14) und / oder zumindest eine Empfangseinheit (16) aufweist oder mit einer solchen verbunden ist.

10. Verfahren nach dem vorhergehenden Anspruch, bei dem mehrere Leitungen (10) des Prüfmoduls (6) gleichzeitig geprüft und hierzu mit den unterschiedlich codierten Prüfsignalen (P) beaufschlagt werden.

11. Verfahren nach einem der beiden vorhergehenden Ansprüche, bei dem mehr als 5 oder mehr als 10 und speziell mehr als 50 Prüfmodule (6) eingesetzt werden.

12. Verfahren nach einem der Ansprüche 9 bis 11, bei dem es sich bei den Prüfmodulen (6) um multifunktionale Prüfmodule (6) handelt, die sowohl zum Erzeugen und Einspeisen als auch zum Erfassen der Prüfsignale (P) ausgebildet sind.

13. Verfahren nach einem der Ansprüche 9 bis 12, bei dem es sich bei den Prüfmodulen (6) um intelligente Prüfmodule (6) handelt, die zur Auswertung des erfassten Prüfsignals (P) ausgebildet sind.

14. Verfahren nach einem der vorhergehenden Ansprüche, bei dem nur ein Teil der einzelnen Leitungen (10) mit den codierten Prüfsignalen (P) gleichzeitig beaufschlagt werden und zumindest einige und vorzugsweise alle weiteren einzelnen Leitungen (10) gleichzeitig im Hinblick auf das Erfassen eines Prüfsignals (P) überprüft werden.

15. Vorrichtung, insbesondere Prüftisch (2) zum Prüfen eines Kabelsatzes (4) insbesondere für ein Fahrzeug, welcher eine Vielzahl von einzelnen Leitungen (10) mit jeweils zwei Leitungsenden (18) aufweist, wobei die Vorrichtung zumindest eine Sendeeinheit (14) zum Einspeisen eines Prüfsignals (P) in das jeweilige eine Leitungsende (18) und zumindest eine Empfangseinheit (16) zum Erfassen des jeweiligen Prüfsignals (P) am anderen Leitungsende (18) aufweist, wobei die Vorrichtung derart ausgebildet ist, dass bei der Prüfung mehrere Leitungen (10) gleichzeitig geprüft werden und hierzu unterschiedlich codierte Prüfsignale (P) angelegt werden.
